# EUROPEAN PATENT APPLICATION

(11) **EP 4 810 974 A1**
(43) Date of publication of application: **23.09.2026**
(21) Application number: 25898780.9
(22) Date of filing: 20.08.2025
(51) Int. Cl.: G01R 31/3842, G01R 31/396, H01M 10/42, H01M 10/48

(54) **METHOD AND APPARATUS FOR PREDICTING RATE CAPABILITY OF SECONDARY BATTERY**

(30) Priority: 29.11.2024 KR 20240175536
(71) Applicant: LG Energy Solution, Ltd., Seoul 07335 (KR)
(72) Inventor: PARK, Hyeonghun, Daejeon 34122 (KR); KANG, Juyoung, Daejeon 34122 (KR); MUN, Byoung Jun, Daejeon 34122 (KR); SUNG, Chang Hyun, Daejeon 34122 (KR)
(74) Representative: Goddar, Heinz J.
(86) International application number: PCT/KR2025/012646
(87) International publication number: WO 2026/116688

(57) **Abstract**

A method for predicting the rate capability of the secondary battery includes measuring each of a plurality of first capacities according to each of a plurality of first currents flowing in the secondary battery cell at each of some of a plurality of temperatures to acquire the plurality of first currents and the plurality of first capacities corresponding to each of the some of the plurality of temperatures, calculating each of a plurality of ion conductivities of the secondary battery cell at each of the plurality of temperatures, generating a rate capability curve representing the rate capability at the some of the temperatures by using the plurality of first currents and the plurality of first capacities, and pluralirty of ion conductivities, at each of the some of the temperatures, and predicting the rate capability data of the secondary battery cell at each of remaining temperatures, excluding the some of the temperatures, among the plurality of temperatures by using the rate capability curve.

## Description

### CROSS-REFERENCE TO RELATED APPLICATION

This application claims priority to and the benefit of Korean Patent Application No. 10-2024-0175536 filed with the Korean Intellectual Property Office on November 29, 2024, the entire contents of which are incorporated herein by reference.

### [Technical Field]

The present disclosure relates to a cell balancing method and a battery pack management system applying the same.

### [Background]

A rate capability is a characteristic related to a speed of charging and discharging, and must satisfy design specifications of a secondary battery.

The rate capability of the secondary battery is measured while changing a temperature of the secondary battery and a magnitude of a current applied to the secondary battery.

Therefore, a lot of time and resources are consumed to measure the rate capability.

A method for predicting rate capability is needed to reduce the time and resources consumed in measuring rate characteristics, but prediction is difficult due to the different rate capability behavior of each secondary battery.

The background description provided herein is for the purpose of generally presenting context of the disclosure. Unless otherwise indicated herein, the materials described in this section are not prior art to the claims in this application and are not admitted to be prior art, or suggestions of the prior art, by inclusion in this section.

### [Summary]

Some embodiments of the present disclosure aim to provide a method and apparatus for predicting a rate capability of a secondary battery, which can reduce the time for measuring the rate capability.

According to an embodiment, a method for predicting rate capability of a secondary battery cell may be provided. The method for predicting rate capability of a secondary battery cell includes: measuring each of a plurality of first capacities according to each of a plurality of first currents flowing in the secondary battery cell at each of some of a plurality of temperatures to acquire the plurality of first currents and the plurality of first capacities corresponding to each of the some of the temperatures; calculating each of a plurality of ion conductivities of the secondary battery cell at each of the plurality of temperatures; generating a rate capability curve representing the rate capability at the some of the temperatures by using the plurality of first currents and the plurality of first capacities, and the ion conductivity, at each of the some of the temperatures; and predicting rate capability data of the secondary battery cell at each of remaining temperatures, excluding the some of the temperatures, among the plurality of temperatures by using the rate capability curve.

The predicting the rate capability data of the secondary battery cell may include predicting the plurality of first capacities according to each of the plurality of first currents flowing in the secondary battery cell at the each of remaining temperatures by using the rate capability curve.

The generating a rate capability curve may include converting each of a plurality of first capacities according to each of a plurality of first currents at each of the some of the temperatures into each of a plurality of capacity ratios according to each of a plurality of second currents by using an ion conductivity and a reference capacity at each of the some of the temperatures, and the rate capability curve may represent the plurality of second currents and the plurality of capacity rates at each of the some of the temperatures.

The converting may include converting the plurality of first currents at each of the some of the temperatures into the plurality of second currents by dividing each of the plurality of first currents by the ion conductivity at each of the some of the temperatures at each of the some of the temperatures; and converting the plurality of first capacities at each of the some of the temperatures into the plurality of capacity ratios by dividing the plurality of first capacities by the reference capacity at each of the some of the temperatures.

The predicting the rate capability data of the secondary battery cell may include dividing the rate capability curve into a first section and a second section; calculating the plurality of first currents at each of the remaining temperatures by multiplying each of a plurality of second currents belonging to the first section by the ion conductivity of each of the remaining temperatures; and calculating the plurality of first capacities at each of the remaining temperatures by multiplying each of a plurality of capacity ratios belonging to the first section by the reference capacity at each of the remaining temperatures.

The predicting the rate capability data of the secondary battery cell further may include calculating, at each of the remaining temperatures, a plurality of first capacities according to each of the plurality of first currents for the second section by using the ion conductivity and the reference capacity of each of the remaining temperatures, based on a relationship between each of a plurality of second currents and each of a plurality of first capacities in the second section for each of the plurality of first currents.

The relationship may follow a function that adds, to each of a plurality of first values obtained by multiplying each of the plurality of second currents by a first constant, both the reference capacity and a second value obtained by dividing a second constant by the ionic conductivity at each of the remaining temperatures.

The dividing may include calculating a change amount of the capacity ratio with respect to a change amount of the second current from the rate capability curve; and setting the first section and the second section through a comparison of the change amount of the capacity ratio with respect to the change amount of the second current and a threshold value.

According to another embodiment, a secondary battery rate capability prediction apparatus for predicting a rate capability of a secondary battery may be provided. The secondary battery rate capability prediction apparatus includes a measuring device configured to measure each of a plurality of first capacities according to each of a plurality of first currents flowing in the secondary battery cell; and a controller configured to calculate each of a plurality of ion conductivities of the secondary battery cell at each of the plurality of temperatures, to generate a rate capability curve representing the rate capability at the some of the temperatures by using the plurality of first currents and the plurality of first capacities, and the ion conductivity, at each of the some of the temperatures, and to predict a plurality of first capacities according to each of a plurality of first currents flowing in the secondary battery cell at each of remaining temperatures, excluding the some of the temperatures, among the plurality of temperatures by using the rate capability curve.

The controller may be configured to convert each of a plurality of first capacities according to each of a plurality of first currents at each of the some of the temperatures into each of a plurality of capacity ratios according to each of a plurality of second currents by using an ion conductivity and a reference capacity at each of the some of the temperatures, and to generate the rate capability curve representing the plurality of second currents and the plurality of capacity rates at each of the some of the temperatures.

The controller may be configured to convert the plurality of first currents at each of the some of the temperatures into the plurality of second currents by dividing each of the plurality of first currents by the ion conductivity at each of the some of the temperatures at each of the some of the temperatures, and to convert the plurality of first capacities at each of the some of the temperatures into the plurality of capacity ratios by dividing the plurality of first capacities by the reference capacity at each of the some of the temperatures.

The controller may be configured to divide the rate capability curve into a first section and a second section, to calculate the plurality of first currents at each of the remaining temperatures by multiplying each of a plurality of second currents belonging to the first section by the ion conductivity of each of the remaining temperatures, and to calculate the plurality of first capacities at each of the remaining temperatures by multiplying each of a plurality of capacity ratios belonging to the first section by the reference capacity at each of the remaining temperatures.

The controller may be configured to calculate at each of the remaining temperatures, a plurality of first capacities according to each of the plurality of first currents for the second section by using the ion conductivity and the reference capacity of each of the remaining temperatures, based on a relationship between each of a plurality of second currents and each of a plurality of first capacities in the second section for each of the plurality of first currents.

According to at least one of the embodiments, by predicting rate capability data for the remaining unmeasured test temperatures using rate capability data measured for some of the test temperatures among all test temperatures, the time and resource consumption for measuring the rate capability can be reduced.

### [Brief Description of the Drawings]

FIG. 1 is a diagram illustrating a secondary battery rate capability prediction apparatus according to an embodiment.
FIG. 2 is a diagram illustrating an example of an ion conductivity of a secondary battery cell for all test temperatures according to an embodiment.
FIG. 3 is a graph illustrating an example of measurement data at some test temperatures according to an embodiment.
FIG. 4 is a flowchart illustrating a method for predicting the rate capability of a secondary battery cell at all test temperatures according to one embodiment.
FIG. 5 is a diagram illustrating an example in which each of the plurality of first currents at each test temperature shown in FIG. 3 is converted into each of a plurality of second currents.
FIG. 6 is a diagram illustrating an example of a rate capability capabilities curve according to one embodiment.
FIG. 7 is a diagram illustrating an example of the predicted rate capabilities of a secondary battery cell for the remaining test temperatures according to an embodiment.
FIG. 8 is a diagram illustrating a secondary battery rate capability prediction apparatus according to another embodiment.

### [Detailed Description]

Hereinafter, embodiments will be described in detail with reference to the accompanying drawings so that those skilled in the art to which the present disclosure pertains can easily implement them. However, they may be implemented in various different forms and is not limited to the embodiments described herein. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. The above terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected."

On the other hand, if an element is referred to as "directly connected" to another element, it should be understood that no other element exists in the middle.

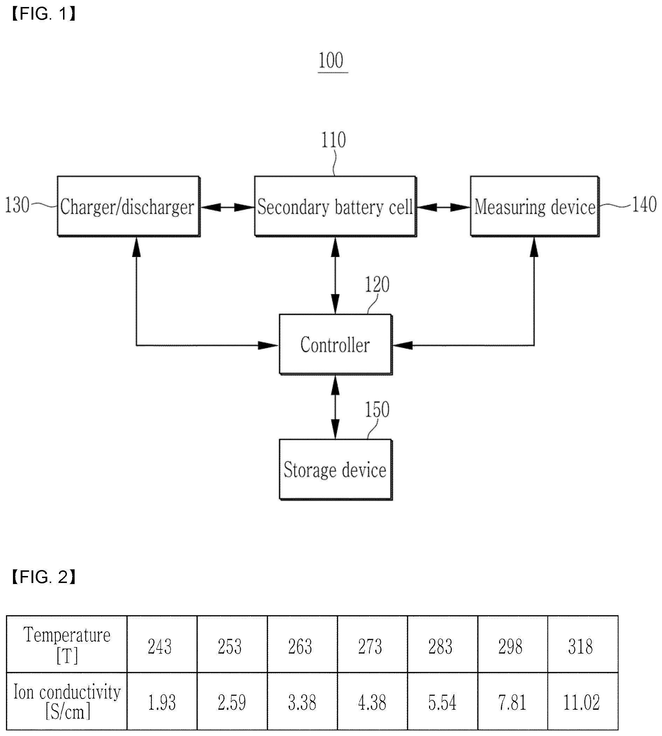

FIG. 1 is a diagram illustrating a secondary battery rate capability prediction apparatus according to an embodiment.

Referring to FIG. 1, a secondary battery rate capability prediction apparatus 100 may predict a rate capability of a secondary battery cell 110 to be tested, and may include a controller 120, a charger/discharger 130, a measuring device 140, and a storage device 150.

The secondary battery cell 110 may be a lithium ion secondary battery cell.

The rate capability is a characteristic according to a charge/discharge rate (C-rate), and may mean how high or low the capacity retention is as the charge and discharge rate increases. The rate capability may be represented as capacity according to temperature and charge/discharge rate.

The charger/discharger 130 may charge the secondary battery cell 110 or discharge the secondary battery cell 110 based on rate capability test conditions of the controller 120. The charger/discharger 130 may charge the secondary battery cell 110 in a charging period and discharge the secondary battery cell 110 in a discharging period. The rate capability test conditions may include test temperature, charge/discharge rate, charge voltage, and discharge voltage.

The measuring device 140 may calculate the capacity of the secondary battery cell 110 based on a measurement control of the controller 120.

In some embodiments, in order to predict the rate capacity of the secondary battery cell 110, the measuring device 140 may calculate the amount of charge released while the secondary battery cell 110 is discharging in the discharging period, that is, the discharge capacity, based on the measurement control of the controller 120.

The controller 120 may set rate capability test conditions and control the charger/discharger 130 and the measuring device 140 according to the rate capability test conditions in order to acquire measurement data necessary for predicting the rate capability of the secondary battery cell 110.

The rate capability of the secondary battery cell 110 may be calculated from capacities measured at various test temperatures and various charge/discharge rates. In this case, a significant amount of time and resources are consumed to measure the capacities of the secondary battery cell 110 at various test temperatures and various charge/discharge rates.

According to an embodiment, the controller 120, instead of measuring the capacity of the secondary battery cell 110 for each charge/discharge rate for all test temperatures for rate capacity measurement, may measure the capacity of the secondary battery cell 110 for each charge/discharge rate for only some of the test temperatures among all test temperatures, and predict the capacity of the secondary battery cell 110 for each charge/discharge rate for the remaining test temperatures, based on the capacity of the secondary battery cell 110 for each charge/discharge rate measured for some of the test temperatures and the ion conductivity, thereby calculating the rate capability of the secondary battery cell 110 at all test temperatures.

If the rate capability of the secondary battery cell 110 does not meet the design specifications of the secondary battery cell 110 required, the controller 120 may change design parameters of the secondary battery cell 110 and calculate the rate capability of the secondary battery cell 110. The design parameters may be, for example, at least one of an ion conductivity, an electrode thickness of the secondary battery cell 110, and a porosity for an electrode of the secondary battery cell 110.

The controller 120 may calculate the ion conductivity for all test temperatures according to the relationship of the ion conductivity with respect to temperature.

For example, when the ion conductivity is D and the temperature is T, and Log(D) and 1/T have a linear relationship, the controller 120 may calculate the ion conductivity for all test temperatures from the linear relationship between Log(D) and 1/T.

The storage device 150 may store the capacity of the secondary battery cell 110 for each charge/discharge rate measured for some of the test temperatures and the ion conductivity for all test temperatures.

In some embodiments, since the charge/discharge rate represents the charge/discharge current for the rated capacity of the secondary battery cell 110, the charge/discharge rate may be used interchangeably with the charge/discharge current.

FIG. is a diagram illustrating an example of an ion conductivity of a secondary battery cell for all test temperatures according to an embodiment.

As shown in FIG. 2, it is assumed that the number of all test temperatures for predicting the rate capability is 7, and the all test temperatures are 243 degrees, 253 degrees, 263 degrees, 273 degrees, 283 degrees, 298 degrees, and 318 degrees. Here, the temperature is shown as an absolute temperature K, but is not limited thereto.

The controller 120 may calculate ion conductivity for each of all the test temperatures according to the relationship of a plurality of ion conductivities according to a plurality of temperatures, and the calculated ion conductivity for each of all the test temperatures may be stored in the storage device 150.

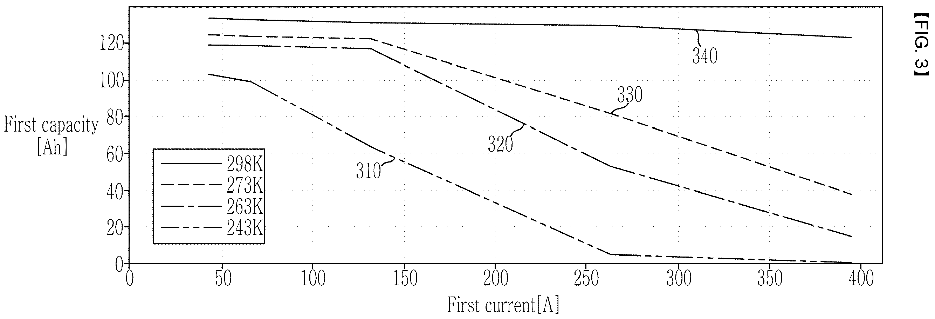

FIG. 3 is a graph illustrating an example of measurement data at some test temperatures according to an embodiment.

As illustrated in FIG. 3, a plurality of charge/discharge capacities 310, 320, 330, and 340 according to each of a plurality of charge/discharge currents may be measured at each of four test temperatures, which are 243 degrees, 263 degrees, 273 degrees, and 298 degrees, among all the test temperatures, and the plurality of charge/discharge capacities 310, 320, 330, and 340 according to the plurality of charge/discharge currents at the four test temperatures measured in this way may be stored in the storage device 150.

In FIG. 3, a discharge current is shown as the charge/discharge current, and a discharge capacity is shown as the charge/discharge capacity, but it may not be limited thereto.

The plurality of discharge capacities 310, 320, 330, and 340 according to the plurality of discharge currents at each of the four test temperatures shown in FIG. 3 may be measured as follows.

The controller 120 may transmit test conditions including a charge/discharge current of aA, a charge voltage of V1, and a discharge voltage of V2 to the charger/discharger 130 while maintaining a test temperature of 243 degrees, and may transmit a measurement control signal to the measuring device 140 to measure the discharge capacity in the discharging period.

The charger/discharger 130 may charge the secondary battery cell 110 to the V1 voltage with a charge/discharge current of aA in the charging period, and may discharge the secondary battery cell 110 to the V2 voltage with a charge/discharge current of aA in the discharging period.

The measuring device 140 may measure the discharge capacity released while the secondary battery cell 110 is discharging in the discharging period, and may store the measured discharge capacity in the storage device 150 corresponding to the charge/discharge current of aA.

The controller 120 may change the charge/discharge current to bA and transmit test conditions including a charge/discharge current of bA, a charge voltage of V1 and a discharge voltage of V2 to the charger/discharger 130, and may transmit a measurement control signal to the measuring device 140 to measure the discharge capacity in the discharging period.

The charger/discharger 130 may charge the secondary battery cell 110 to the V1 voltage with a charge/discharge current of bA in the charging period, and may discharge the secondary battery cell 110 to the V2 voltage with a charge/discharge current of bA in the discharging period.

The measuring device 140 may measure the discharge capacity released while the secondary battery cell 110 is discharging in the discharging period, and may store the measured discharge capacity in the storage device 150 corresponding to the charge/discharge current of bA.

In this way, discharge capacities 310 according to each of the discharge currents aA, bA, cA, dA, and eA at the test temperature of 243 degrees may be measured.

Next, the controller 120 may transmit test conditions including a charge/discharge current of aA, a charge voltage of V1, and a discharge voltage of V2 to the charger/discharger 130 while maintaining a test temperature of 263 degrees, and may transmit a measurement control signal to the measuring device 140 to measure the discharge capacity in the discharging period.

The charger/discharger 130 may charge the secondary battery cell 110 to the V1 voltage with a charge/discharge current of aA in the charging period, and may discharge the secondary battery cell 110 to the V2 voltage with a charge/discharge current of aA in the discharging period.

The measuring device 140 may measure the discharge capacity released while the secondary battery cell 110 is discharging in the discharging period, and may store the measured discharge capacity in the storage device 150 corresponding to the charge/discharge current of aA.

The controller 120 may change the charge/discharge current to bA and transmit test conditions including a charge/discharge current of bA, a charge voltage of V1 and a discharge voltage of V2 to the charger/discharger 130, and may transmit a measurement control signal to the measuring device 140 to measure the discharge capacity in the discharging period.

The charger/discharger 130 may charge the secondary battery cell 110 to the V1 voltage with a charge/discharge current of bA in the charging period, and may discharge the secondary battery cell 110 to the V2 voltage with a charge/discharge current of bA in the discharging period.

The measuring device 140 may measure the discharge capacity released while the secondary battery cell 110 is discharging in the discharging period, and may store the measured discharge capacity in the storage device 150 corresponding to the charge/discharge current of bA.

In this way, discharge capacities 320 according to each of the discharge currents aA, bA, cA, dA, and eA at the test temperature of 263 degrees may be measured.

In the same manner, a plurality of discharge capacities 330 and 340 according to each of the discharge currents of aA, bA, cA, dA, and eA may be measured at each of the test temperatures of 273 degrees and 298 degrees.

For example, a may be set to a value corresponding to 1/3 of c, b may be set to a value corresponding to 1/2 of c, d may be set to a value corresponding to 2 times c, and e may be set to a value corresponding to 3 times c. That is, if c is set to 135A, then a may be set to 45A, b to 67.5A, d may be set to 270A, and e may be set to 405A. a, b, c, d, and e are values corresponding to an arbitrary design, but are not limited thereto.

Hereinafter, a method for predicting the rate capability of the secondary battery cell at all test temperatures by using the rate capability of the secondary battery cell measured at each of the four test temperatures shown in FIG. 3 will be described, and for convenience of description, the discharge current will be referred to as a first current, and the discharge capacity will be referred to as a first capacity.

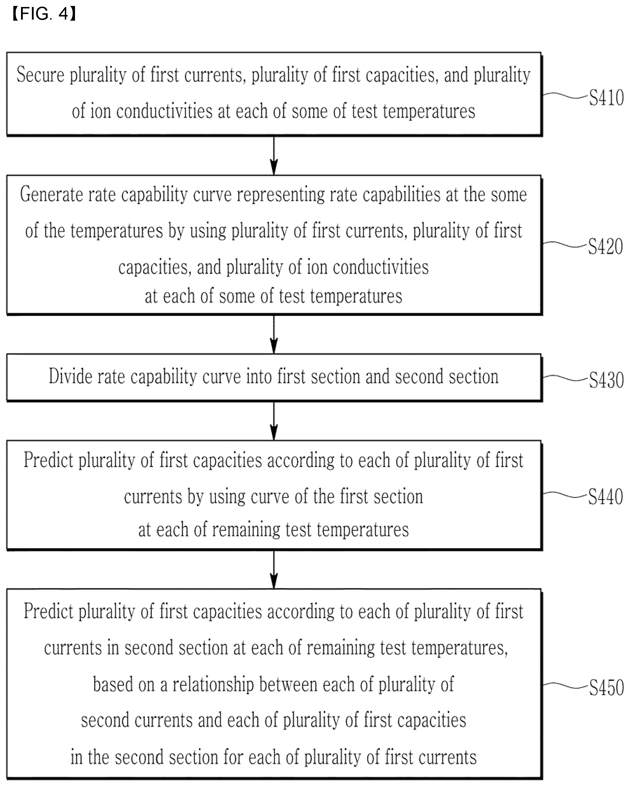

FIG. 4 is a flowchart illustrating a method for predicting the rate capability of a secondary battery cell at all test temperatures according to one embodiment.

Referring to FIG. 4, the controller 120 may secure a plurality of first currents, a plurality of first capacities, and a plurality of ion conductivities at each of four test temperatures, which are some of the test temperatures (S410).

The controller 120 may generate one rate capability curve representing the rate capabilities at the some of the temperatures by using the plurality of first currents, the plurality of first capacities, and the plurality of ion conductivities at each of the some of the test temperatures (S420).

More specifically, since the ionic conductivity of the secondary battery cell 110 varies depending on the temperature, the controller 120 may convert the plurality of first currents at each of the some of the temperatures into a plurality of second currents by dividing each of the plurality of first currents at each of the some of the test temperatures representing the rate capability by the ion conductivity at each of the some of the test temperatures. The second current may represent the first current reflecting the ion conductivity at a corresponding test temperature.

Next, the controller 120 may convert the plurality of first capacities at each of the some of the test temperatures into a plurality of capacity ratios by dividing each of the plurality of first capacities at each of the some of the test temperatures representing the rate capability by a reference capacity. The capacity ratio may represent a value obtained by normalizing the first capacity using the reference capacity.

According to an embodiment, the reference capacity may be the capacity at a first current of 0A.

As such, the controller 120 converts each of the plurality of first capacities at each of the plurality of first currents at each of the some of the test temperatures into each of a plurality of capacity ratios at each of a plurality of second currents, and may generate the rate capability curve representing the plurality of second currents and the plurality of capacity ratios at each of the some of the test temperatures.

The controller (120) may divide the rate capability curve into a first section and a second section (S430). The controller 120 may calculate a change amount of the capacity ratio with respect to a change amount of the second current from the rate capability curve, and the controller 120 may divide the rate capability curve into the first section and the second section by comparing an absolute value of the change amount of the capacity ratio with respect to the change amount of the second current with a threshold value. The controller 120 may set a point where the absolute value of the change amount of the capacity ratio with respect to the change amount of the second current becomes greater than the threshold value in the rate capability curve as a starting point of the first section, and may set a range from the starting point to a point corresponding to the maximum value of the second current as the first section. The controller 120 may set a range from a point where the second current is 0 in the rate capability curve to the starting point of the first section as the second section.

The controller 120 predicts a plurality of first capacities according to each of a plurality of first currents by using the curve of the first section at each of the remaining test temperatures excluding the some of the test temperatures among all the test temperatures (S440). Specifically, the controller 120 may calculate a plurality of first currents at each of the remaining test temperatures by multiplying each of a plurality of second currents belonging to the first section by the ion conductivity of each of the remaining test temperatures. In addition, the controller (120) may calculate a plurality of first capacities at each of the remaining test temperatures by multiplying each of a plurality of capacity ratios belonging to the first section by the reference capacity.

Next, the controller 120 predicts a plurality of first capacities according to each of a plurality of first currents in the second section at each of the remaining test temperatures, based on a relationship between each of a plurality of second currents and each of a plurality of first capacities in the second section for each of the plurality of first currents (S450).

In some embodiments, each of a plurality of second currents and each of a plurality of first capacities in the second section for each of the plurality of first currents may have a relationship as in Equation 1. $C = {C}_{0} + \left(\frac{a}{I}+b\right) \frac{I}{D} = {C}_{0} + \frac{\left(a+bI\right)}{D}$

Here, C represents the first capacity [Ah], and C₀ represents the capacity [Ah] when the second current value is 0 (i.e., D=∞). I represents the first current [A], a and b may be constant values, and D may represent the ionic conductivity [S/cm]. C₀, a and b may be obtained through fitting.

When the controller 120 substitutes the ion conductivity of each of the remaining test temperatures into D in Equation 1 and substitutes each of the plurality of first currents into I in Equation 1, a plurality of first capacities according to each of the plurality of first currents may be calculated.

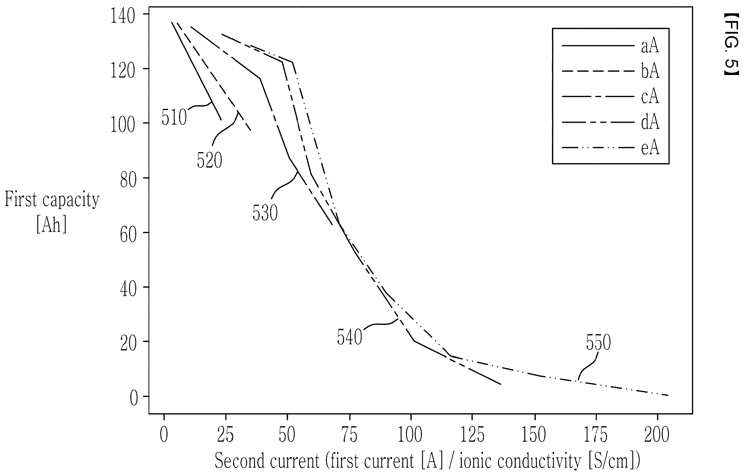

FIG. 5 is a diagram illustrating an example in which each of the plurality of first currents at each test temperature shown in FIG. 3 is converted into each of a plurality of second currents.

As shown in FIG. 5, the controller 120 convert each of the first currents of aA, bA, cA, dA, and eA at each of the some of the temperatures into the plurality of second currents by dividing each of the first currents of aA, bA, cA, dA, and eA at each of the four test temperatures representing the rate capability by the ion conductivity at each of the some of the test temperatures, and may calculate a plurality of first capacities 510, 520, 530, 540, and 550 according to each of the plurality of second currents at each of the first currents of aA, bA, cA, dA, and eA.

The controller 120, for at least the second section, may derive a fitting function of Equation 1 by using the plurality of first capacities 510, 520, 530, 540, and 550 for each of the plurality of second currents at each of the first currents of aA, bA, cA, dA, and eA. Since the slope of the fitting function has a linear relationship with respect to (1/first current), it may be expressed as (a/I+b), and the y-intercept of the fitting function may be expressed as C₀ independently of (1/first current).

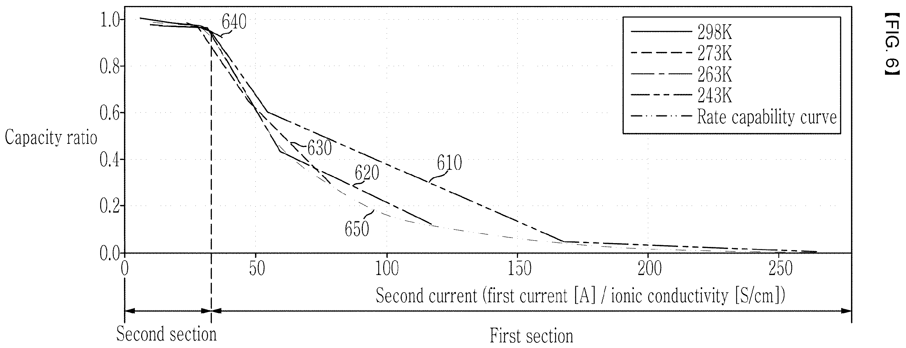

FIG. 6 is a diagram illustrating an example of a rate capability curve according to one embodiment.

Referring to FIG. 6, the plurality of first capacities according to each of the plurality of first currents at each of the four test temperatures shown in FIG. 3 may be converted into a plurality of capacity ratios 610, 620, 630, and 640 according to each of a plurality of second currents at each of the four test temperatures.

A rate capability curve 650 may represent the plurality of capacity ratios 610, 620, 630, and 640 according to each of the plurality of second currents at each of the four test temperatures.

The rate capability curve 650 may be divided into a second section and a first section based on the change amount of the capacity ratio with respect to the change amount of the second current.

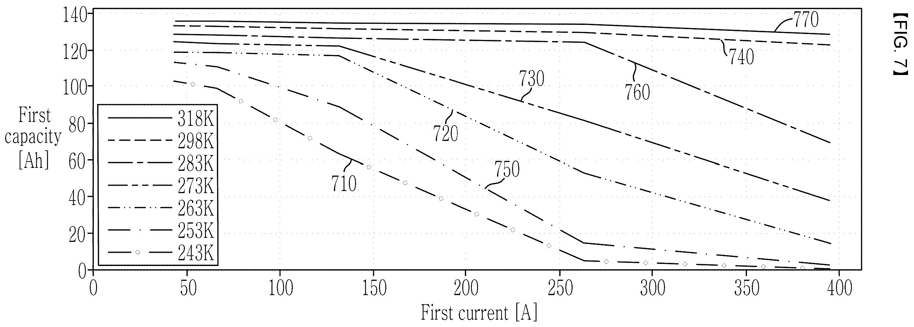

FIG. 7 is a diagram illustrating an example of the predicted rate of a secondary battery cell for the remaining test temperatures according to an embodiment.

In FIG. 7, 710, 720, 730, and 740 represent a plurality of first capacities according to each of a plurality of first currents, which is the rate capability of the secondary battery cell 110 measured at each of the test temperatures of 243 degrees, 263 degrees, 273 degrees, and 298 degrees shown in FIG. 3.

According to an embodiment, a plurality of first capacities 750, 760, and 770 according to each of a plurality of first currents at each of the remaining test temperatures of 253 degrees, 283 degrees, and 318 degrees may be predicted from the plurality of first capacities 710, 720, 730, and 740 according to each of the plurality of first currents acquired through measurement at each of the test temperatures of 243 degrees, 263 degrees, 273 degrees, and 298 degrees.

The plurality of first capacities 750 according to each of the plurality of first currents at the test temperature of 253 degrees may be calculated by being divided into a first section and a second section, as described above. The plurality of first capacities 750 according to each of the plurality of first currents in the first section may be calculated by multiplying each of a plurality of second currents belonging to the first section of the rate capability curve 650 shown in FIG. 6 by the ion conductivity of the test temperature of 253 degrees, and multiplying each of a plurality of capacity ratios belonging to the first section of the rate capability curve 650 by the reference capacity at the test temperature of 253 degrees calculated from Equation 1. The plurality of first capacities 750 according to each of the plurality of first currents in the second section may be calculated by substituting the ionic conductivity at a test temperature of 253 degrees into D of Equation 1 and substituting each of the plurality of first currents into I of Equation 1.

The plurality of first capacities 760 according to each of the plurality of first currents at the test temperature of 283 degrees may be calculated by being divided into a first section and a second section, as described above. The plurality of first capacities 760 according to each of the plurality of first currents in the first section may be calculated by multiplying each of a plurality of second currents belonging to the first section of the rate capability curve 650 shown in FIG. 6 by the ion conductivity of the test temperature of 283 degrees, and multiplying each of a plurality of capacity ratios belonging to the first section of the rate capability curve 650 by the reference capacity at the test temperature of 283 degrees calculated from Equation 1.

The plurality of first capacities 760 according to each of the plurality of first currents in the second section may be calculated by substituting the ionic conductivity at a test temperature of 283 degrees into D of Equation 1 and substituting each of the plurality of first currents into I of Equation 1.

The plurality of first capacities 770 according to each of the plurality of first currents at the test temperature of 318 degrees may be calculated by being divided into a first section and a second section, as described above. The plurality of first capacities 770 according to each of the plurality of first currents in the first section may be calculated by multiplying each of a plurality of second currents belonging to the first section of the rate capability curve 650 shown in FIG. 6 by the ion conductivity of the test temperature of 318 degrees, and multiplying each of a plurality of capacity ratios belonging to the first section of the rate capability curve 650 by the reference capacity at the test temperature of 318 degrees calculated from Equation 1. The plurality of first capacities 770 according to each of the plurality of first currents in the second section may be calculated by substituting the ionic conductivity at a test temperature of 318 degrees into D of Equation 1 and substituting each of the plurality of first currents into I of Equation 1.

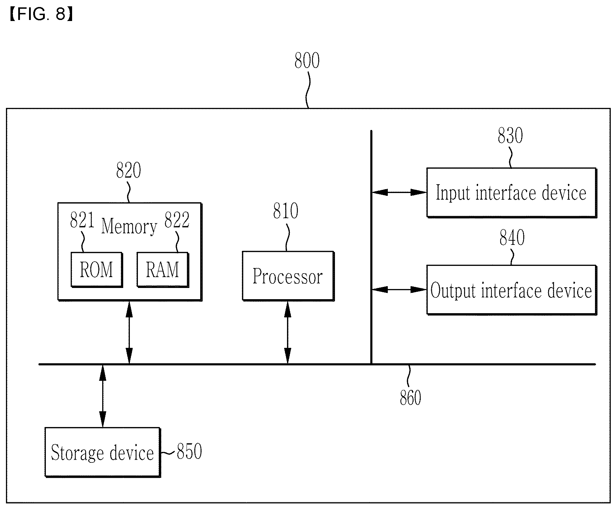

FIG. 8 is a diagram illustrating a secondary battery rate capability prediction apparatus according to another embodiment.

Referring to FIG. 8, the secondary battery rate capability prediction apparatus 800 may represent a computing device in which the secondary battery rate prediction method described above is implemented.

The secondary battery rate capability prediction apparatus 800 may include at least one of processor 810, a memory 820, an input interface device 830, an output interface device 840, and a storage device 850. Each of the components may be connected by a bus 860 and may communicate with each other. In addition, each of the components may be connected through an individual interface or an individual bus centered on the processor 810, rather than the bus 860.

The processor 810 may be implemented in various types such as an application processor (AP), a central processing unit (CPU), a graphic processing unit (GPU), etc., and may be any semiconductor device that executes commands stored in the memory 820 or the storage device 850. The processor 810 may execute program commands stored in at least one of the memory 820 and the storage device 850. The processor 810 may store program commands for implementing at least some functions of the controller 120 described in FIGS. 1 and 4 in the memory 820, and perform the secondary battery rate capability prediction operation of the controller 120 described with reference to FIGS. 1 to 7.

The memory 820 and the storage device 850 may include various types of volatile or non-volatile storage media. For example, the memory 820 may include read-only memory (ROM) 821 and random access memory (RAM) 822. In an embodiment, the memory 820 may be located inside or outside the processor 810, and the memory 820 may be connected to the processor 810 through various means already known.

The input interface device 830 may be configured to provide data to the processor 810.

The output interface device 840 may be configured to output data from the processor 810.

In some embodiments, the input interface device 830 and the output interface device 840 may be a network interface device connected to a network.

At least a part of the method for predicting a rate capability of a secondary battery according to an embodiment may be implemented as a program or software executed on a computing device, and the program or software may be stored on a computer-readable medium.

Additionally, at least some of the methods for predicting a rate capability of a secondary battery may be implemented by hardware that can be electrically connected to a computing device.

Although the embodiments of the present disclosure have been described in detail above, the scope of the present disclosure is not limited thereto, and various modifications and improvements made by those skilled in the art using the basic concept of the present disclosure defined in the following claims also fall within the scope of the present disclosure.

## Claims

1. A method for predicting a rate capability of a secondary battery cell by a secondary battery rate capability prediction apparatus, the method comprising:
measuring each of a plurality of first capacities according to each of a plurality of first currents flowing in the secondary battery cell at each of some of a plurality of temperatures to acquire the plurality of first currents and the plurality of first capacities corresponding to each of the some of the plurality of temperatures;
calculating each of a plurality of ion conductivities of the secondary battery cell at each of the plurality of temperatures;
generating a rate capability curve representing the rate capability at the some of the temperatures by using the plurality of first currents and the plurality of first capacities, and the plurality of ion conductivities of the secondary battery cell, at each of the some of the temperatures; and
predicting the rate capability data of the secondary battery cell at each of remaining temperatures, excluding the some of the temperatures, among the plurality of temperatures by using the rate capability curve.

2. The method of claim 1, wherein
predicting the rate capability data of the secondary battery cell includes
predicting the plurality of first capacities according to each of the plurality of first currents flowing in the secondary battery cell at the each of remaining temperatures by using the rate capability curve.

3. The method of claim 1, wherein
generating the rate capability curve includes
converting each of the plurality of first capacities according to each of the plurality of first currents at each of the some of the temperatures into each of a plurality of capacity ratios according to each of a plurality of second currents by using each of the plurality of ion conductivities and a reference capacity at each of the some of the temperatures, and
wherein the rate capability curve represents the plurality of second currents and the plurality of capacity rates at each of the some of the temperatures.

4. The method of claim 3, wherein
converting each of the plurality of first capacities includes
converting the plurality of first currents at each of the some of the temperatures into the plurality of second currents by dividing each of the plurality of first currents by each of the plurality of ion conductivities at each of the some of the temperatures; and
converting the plurality of first capacities at each of the some of the temperatures into the plurality of capacity ratios by dividing the plurality of first capacities by the reference capacity at each of the some of the temperatures.

5. The method of claim 4, wherein
the predicting the rate capability data of the secondary battery cell includes
dividing the rate capability curve into a first section and a second section;
calculating the plurality of first currents at each of the remaining temperatures by multiplying each of a plurality of second currents belonging to the first section by each of the plurality of ion conductivities at each of the remaining temperatures; and
calculating the plurality of first capacities at each of the remaining temperatures by multiplying each of a plurality of capacity ratios belonging to the first section by the reference capacity at each of the remaining temperatures.

6. The method of claim 5, wherein
the predicting the rate capability data of the secondary battery cell further includes
calculating, at each of the remaining temperatures, the plurality of first capacities according to each of the plurality of first currents for the second section by using each of the plurality of ion conductivities and the reference capacity of each of the remaining temperatures, based on a relationship between each of a plurality of second currents and each of the plurality of first capacities in the second section for each of the plurality of first currents.

7. The method of claim 6, wherein
the relationship follows a function that adds, to each of a plurality of first values obtained by multiplying each of the plurality of second currents by a first constant, both the reference capacity and a second value obtained by dividing a second constant by the ionic conductivity at each of the remaining temperatures.

8. The method of claim 5, wherein
dividing the rate capability curve includes
calculating a change amount of the capacity ratio with respect to a change amount of the second current from the rate capability curve; and
setting the first section and the second section through a comparison of the change amount of the capacity ratio with respect to the change amount of the second current and a threshold value.

9. A secondary battery rate capability prediction apparatus for predicting a rate capability of a secondary battery, the apparatus comprising:
a measuring device configured to measure each of a plurality of first capacities according to each of a plurality of first currents flowing in the secondary battery cell; and
a controller configured to
calculate each of a plurality of ion conductivities of the secondary battery cell at each of the plurality of temperatures,
generate a rate capability curve representing the rate capability at the some of the temperatures by using the plurality of first currents and the plurality of first capacities, and the plurality of ion conductivities of the secondary battery cell, at each of the some of the temperatures, and
predict the plurality of first capacities according to each of a plurality of first currents flowing in the secondary battery cell at each of remaining temperatures, excluding the some of the temperatures, among the plurality of temperatures by using the rate capability curve.

10. The apparatus of claim 9, wherein
the controller is further configured to convert each of the plurality of first capacities according to each of the plurality of first currents at each of the some of the temperatures into each of a plurality of capacity ratios according to each of a plurality of second currents by using each of the plurality of ion conductivities and a reference capacity at each of the some of the temperatures, and to generate the rate capability curve representing the plurality of second currents and the plurality of capacity rates at each of the some of the temperatures.

11. The apparatus of claim 10, wherein
the controller is further configured to convert the plurality of first currents at each of the some of the temperatures into the plurality of second currents by dividing each of the plurality of first currents by each of the plurality of ion conductivities at each of the some of the temperatures, and to convert the plurality of first capacities at each of the some of the temperatures into the plurality of capacity ratios by dividing the plurality of first capacities by the reference capacity at each of the some of the temperatures.

12. The apparatus of claim 11, wherein
the controller is further configured to divide the rate capability curve into a first section and a second section, to calculate the plurality of first currents at each of the remaining temperatures by multiplying each of a plurality of second currents belonging to the first section by each of the plurality of ion conductivities at each of the remaining temperatures, and to calculate the plurality of first capacities at each of the remaining temperatures by multiplying each of a plurality of capacity ratios belonging to the first section by the reference capacity at each of the remaining temperatures.

13. The apparatus of claim 12, wherein
the controller is further configured to calculate, at each of the remaining temperatures, the plurality of first capacities according to each of the plurality of first currents for the second section by using each of the plurality of ion conductivities and the reference capacity of each of the remaining temperatures, based on a relationship between each of a plurality of second currents and each of the plurality of first capacities in the second section for each of the plurality of first currents.
